# EUROPEAN PATENT APPLICATION

(11) **EP 4 379 427 A1**
(43) Date of publication of application: **05.06.2024**
(21) Application number: 22383168.6
(22) Date of filing: 01.12.2022
(51) Int. Cl.: G01T 1/02, G01T 1/24, H01L 27/00

(54) **SILICON CARBIDE DOSIMETER FOR HIGH DOSE PULSED RADIATION**

(71) Applicant: Consejo Superior De Investigaciones Científicas, 28006 Madrid (ES)
(72) Inventor: GODIGNON, Philippe Raymond M., 08193 Barcelona (ES); FLETA CORRAL, Maria Celeste, 08193 Barcelona (ES); PELLEGRINI, Giulio, 08193 Barcelona (ES); GUARDIOLA SALMERON, Consuelo, 08193 Barcelona (ES)
(74) Representative: Pons

(57) **Abstract**

The invention relates to a diode for measuring the dose delivered at ultra-high doserate, to a dosimeter comprising such diode and to the use of such diode or system.More particularly, the device comprises a SiC based PiN diode structure. The present invention also relates to a dosimeter comprising the device previously described; a readout integrated circuit unit connected to the device; and a processing unit connected to the readout integrated circuit. The present invention also relates to the use of the diode or the dosimeter as previously described.

## Description

The invention relates to a diode for measuring the dose delivered at ultra-high dose-rate, to a dosimeter comprising such diode and to the use of such diode or system.

More particularly, the device comprises a SiC based PiN diode structure. The present invention also relates to a dosimeter comprising the device previously described; a readout integrated circuit unit connected to the device; and a processing unit connected to the readout integrated circuit. The present invention also relates to the use of the diode or the dosimeter as previously described.

### BACKGROUND ART

Irradiation in medicine is the process by which a human is exposed to radiation. Most frequently, the term radiation refers to ionizing radiation. Ionizing radiations are generated by different sources which may be natural, e.g. cosmic rays or terrestrial radiations, or artificial, e.g. medical or industrial uses of radiations.

Radiotherapy (RT) is the medical use of ionizing radiation to treat cancer. About 52% of cancer patients receive RT at least once during their treatment. The effects of ionizing radiation depends on the type of radiation emitted and the absorbed dose. The term absorbed dose describes the amount of radiation absorbed by a person. The unit for absorbed dose is the Gray (Gy). Absorbed dose refers to the energy that is deposited locally by unit of mass in an absorbing medium from ionizing radiation. A dose may be delivered at a high dose rate or at low dose rate, for instance by multiple fractionated doses.

During the last years, new RT treatment modalities are rapidly being researched, one of the most promising is the Ultra High Dose-Rate Radiotherapy (UHDR) or FLASH therapy [Sung, et al. CA: a cancer journal for clinicians 71.3 (2021): 209-249]. The main characteristic of this kind of treatment is that the delivered dose (≥40 Gy/s) is several orders of magnitude faster than the applied dose in traditional RT (~0.05Gy/s) [Favaudon, et al. Science Translational Medicine, Vol. 6, Issue 245, pp. 245Ra93, 2014]. This approach has been found to elicit significant sparing of healthy tissues with equal or better probability of tumour control. This so-called FLASH effect may overcome the dose-limiting radiation toxicity, opening a new paradigm in RT treatments. The FLASH phenomenon was first demonstrated by the use of electron sources, and then using proton and carbon ion beams.

The design of clinical accelerators operating at FLASH dose-rates has had big advances due to the growing interest among the oncology community; it is expected that those machines could be operational to treat humans in 3-5 years. One of the challenges to validate the preclinical studies and enable the clinical implementation of FLASH is the development of dosimetry systems that allow accurate dose measurements and beam monitoring.

Detection techniques traditionally employed in conventional RT are not a valid option in FLASH therapy, because they can be heavily affected by the dose rates and dose per pulse present in UHDR beams [McManus, et al. Scientific reports 10.1 (2020): 1-11]. There are a few works dealing with the limitations of traditional dosimetry methods in UHDR beams, in particular, Gomez et al. [Gómez, et al. Medical Physics (2022)] has created an ultra-thin parallel plate IC that can be used in UHDR beams with minimal recombination, but there are no semiconductor-based dosimeters for FLASH therapy. At present, only passive systems (e.g. radiochromic films, alanine) have been successfully used for dosimetry with UHDR radiation beams. However, a delay of hours or even days can be needed in order to get the response from these passive detectors.

Semiconductor-based active dosimeters (silicon and diamond) are also widely used for active dosimetry in radiotherapy, but they suffer from dose rate dependence, saturation effects and non-linearity with high dose rate beams. Silicon is also sensitive to light and temperature variations and its radiation hardness is only moderate. Diamond is an expensive material, has repeatability issues and is not available in high-quality large wafers, so its commercial potential is limited and 2D-arrays of diamond detectors are not economically viable.

Silicon carbide (SiC) is another semiconductor that has enjoyed a rapid growth in recent years thanks to its use in power electronics, and its physical properties make it a very promising material for radiation dosimetry. The polytype of SiC more interesting for radiation detection applications is 4H-SiC as it has the widest bandgap and a high, almost isotropic, electronic mobility). The wide band-gap of SiC makes it insensitive to visible light and temperature variations, unlike silicon. SiC also has a higher displacement energy threshold and thus a higher radiation hardness than silicon. Additionally, SiC has a higher thermal conductivity, which makes it more resistant to thermal shocks, and better tissue equivalence that makes it suitable for applications in radiation therapy. Furthermore, SiC has a more mature technology that diamond allowing to produce complex and reproducible structures and a good price-performance ratio. Currently, high quality, low defect density SiC is available up to 200 mm wafers. However, at the moment SiC radiation detectors do not exist in the commercial market.

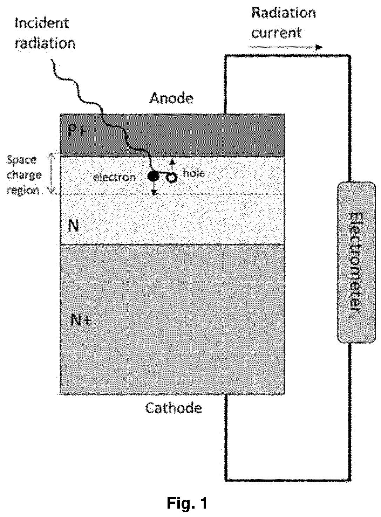

A diode dosimeter is a semiconductor diode operated in short-circuit mode (Fig. 1). Incident ionizing radiation generates a current by creating pairs in the natural space-charge region that are separated by the internal electric field produced by the built-in potential and also creating excess minority carriers in the neutral regions which diffuse to the depleted region and are collected. The radiation-induced current is proportional to the radiation dose rate and its integral, the total charge collected, is proportional to the absorbed dose in the semiconductor [Shi et al, Med. Phys. 30 (2003)].

Deviations of response linearity of diode dosimeters at high radiation dose rates have been observed and correlated with the presence of a series resistance in the diode that, with high instantaneous radiation-induced currents, produces a voltage drop opposite to the built-in potential and hinders charge collection. This series resistance is caused by the contact resistance between metal and semiconductor, the resistance of the top and back metals, the finite conductivity of the semiconductor material and other general resistances [Kranzer et al 2022 Phys. Med. Biol. 67 075002, Marinelli et al 2022 Med. Phys 49 1902].

There is therefore the need for a dosimeter to measure in real-time the dose delivered under ultra-high dose-rate with a high linearity response

### SUMMARY OF THE INVENTION

The present invention discloses a novel diode for measuring the dose delivered at ultra-high dose-rate.

Thus, a diode dosimeter with an extended range of linear operation for high-dose pulsed radiation is achieved by a combination of:
Low radiation-induced current through reduced sensitivity by using a wide band gap semiconductor, for example 6H-SiC, 4H-SiC, diamond or GaN, and a sensitive volume of equal or less than 10 mm³.

A diode built-in potential higher than 1 V, for example by implementing a p-n junction instead of a Schottky junction.

A series resistance of less than 1 kΩ composed of low contact and metal resistances achieved through an optimized fabrication process.

These diode dosimeters with extended range of linear operation not only are useful for dosimetry in FLASH therapy beams. They also be used for other radiation therapy modalities where dosimeters with high dose rate response and good radiation hardness are needed, such as intra-operative radiation therapy (IORT) where dose rates can be up to 150 mG/pulse, and high dose rate (HDR) brachytherapy.

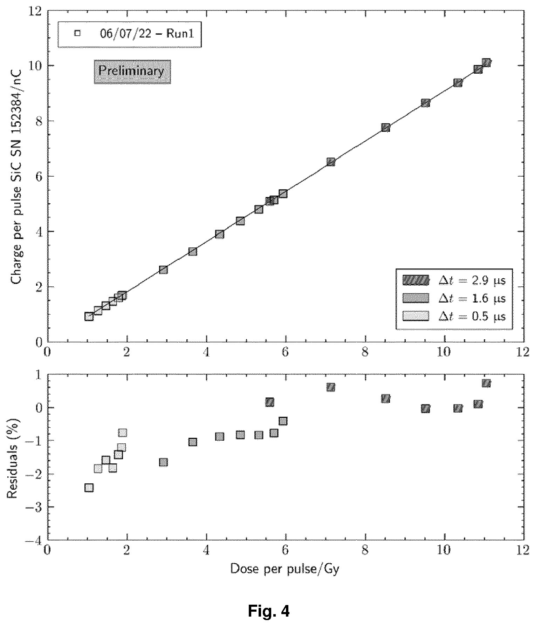

The term "sensitive volume" as used herein refers to the volume defined by space charge region, see Fig. 4. In this volume an electron-hole pair created by the impinging radiation will be swept by the electric field to the electrodes where they will be collected and will create a signal in the detector.

The term "built-in potential" as used herein refers to any potential difference formed across the junction in a diode junction, that without an external applied voltage, it reaches an equilibrium condition. Deviations of response linearity of diode dosimeters at high radiation dose rates have been observed and correlated with the presence of a series resistance in the diode that, with high instantaneous radiation-induced currents, produces a voltage drop opposite to the built-in potential and hinders charge collection. A higher built-in potential allows for a larger voltage drop before losing the ability to collect the charge.

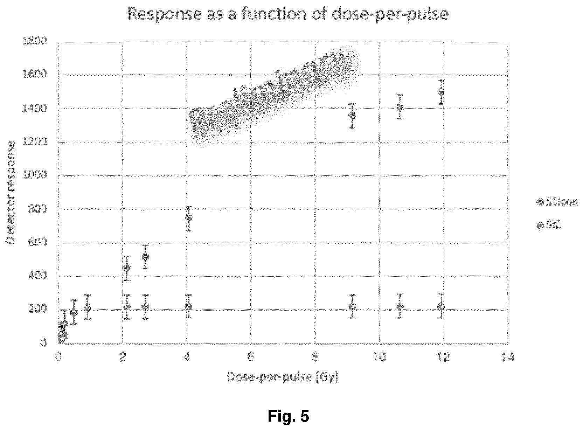

The term "metal resistances" as used herein refers to the resistance of the metal layers that form the metal anode and cathode in the device ("2" and "6" in Figures 1 and 5).

Therefore, a first aspect of the present invention related to a SiC based diode configured to receive particles from an accelerator beam with a PiN structure fabricated on a polytype selected from 4H 6H or 3C-SiC with a n-type doped epilayer with a thickness of between 0.1 and 120 µm and a doping concentration of between 1E13 and 1E15 cm⁻³ that comprising at least a first metallic layer configured to act as a cathode, a n+ substrate layer configured to act as a n++ region, a n-absorption layer, a p+ layer configured to act as a p++ region, a second metallic layer configured to act as an anode, and a dielectric layer configured to act as insulator layer characterized in that an p+ layer configured to act as a p++ region is obtained by sequential p+ implantations of AI+ followed by an annealing temperature ramp of 80 ºC per minute up to 1300 °C and with 60 °C per minute from 1300 ºC to 1670 °C.

In the top surface of this layer, a pn junction is produced by creating a p+ layer by sequential Al⁺ ion implantations (each with a different implantation energy and dose, with the combined effect an optimized p+ profile for increased pn junction efficiency). Al implantation process generate damage in the SiC crystal, which must be recovered through a high temperature annealing with controlled temperature ramps. Moreover, the high temperature annealing must also allow an activation of the Aluminium dopants. Al atoms start to activate in SiC around 1550°C but the optimal temperature for an almost full activation is between 1650°C and 1700°C, depending on the implantation dose. As a consequence, our optimal post-implantation thermal annealing consists in an annealing temperature ramp of 80 ºC per minute from 25°C up to 1300 °C and with 60 °C per minute from 1300 ºC to 1670 °C. This ramp allows a reduction of defects generation during the re-crystalization phase of the SiC. Therefore, the pn junction efficiency is increased, and so are the device performances. A direct heating without any kind of temperature ramp control up to 1670 ºC lead to an insufficient reduction of implantation's defects during the re-crystalization of the SiC. Remaining defects directly affect the electrical performances of the diodes. In general, too high leakage currents in absence of radiation means higher noise and worse detector performance. Regarding the pn junction, size below 0.1 µm are not technically feasible. The way of measuring the resistivity of a semiconductor material is by using a four-point collinear probe.

The term "PiN structure" as used herein refers to a p-n junction semiconductor diode that contains an intrinsic (undoped semiconductor or i-type semiconductor, is a pure semiconductor without any significant dopant species present, the number of charge carriers beeing therefore determined by the properties of the material itself instead of the amount of impurities) or lowly n-doped region between a highly doped p-type semiconductor and a highly doped n-type semiconductor region, wherein for the present invention a lowly n-doped is between 1E13-1E15 cm⁻³ and highly doped is for more than 1E19 cm⁻³.

Thus, a preferred embodiment of the present invention provides the annealing at 1670°C done during 30 minutes. Such temperature is a good compromise between the dopants activation rate (as temperature lower than 1650°C produces a non-optimal dopant activation) and the SiC surface degradation created at higher temperatures.

In another preferred embodiment sequential Al⁺ ion implantations are performed to create the p++ region is in order to obtain a graded p-n junction with the high doping at the interface to form an ohmic contact with a resistivity of less than 5×10⁻⁵ Ω·cm² and non-rectifying (non-directional) metal to semiconductor contact.

In a preferred embodiment a channeling tail control is performed. This results in a lower defect generation in the SiC that reduces the amount of recombination centers (which reduce the carrier lifetimes), and of generation centers (which produce an excess of electron-hole pairs that contribute to leakage current and to noise), thus enhancing the charge collection efficiency of the junction because if in some conditions not all electron-hole pairs produced are collected, then the diode signal (a current) is not proportional to the radiation and response linearity is lost.

Another preferred embodiment of the present invention provides the first metallic layer configured to act as an anode annealed at 950°C in Ar ambient for 2 minutes because it minimizes the contact resistance.

In further embodiment the second metallic layer made of at least 4 metals layers stacked selected from Ti, Ni, Al, W and any combination thereof. In a more further preferred embodiment the stack is Ti/Al/Ti/W and the ratio between Ti and Al layer is 1:3 in weight.

A further embodiment is the "3D diode" where the sidewalls of n-type doped epilayer below the p++ layer are removed by etching to obtain a "mesa" geometry. This removal provides a better definition of the volume sensitive to radiation and thus a better resolution of the measured dose rate and dose and better spatial resolution. The "mesa" is a well-known diode structure where the sidewalls of the n-doped epilayer (volume that is not below the p++ layer) are removed. By etching the volume that is not directly below the p+ layer (which defines the sensitive area of the diode) we remove possible contributions to the signal from charge pairs generated by radiation in the periphery, thus increasing measurement resolution and linearity The mesa structure produces an additional effect that makes for a better radiation detector, in terms of increased spatial resolution thanks to the better definition of the sensitive volume, which is related with increasing the linearity of the signal.

In further embodiment, the PiN structure is surrounded by an extraction ring to isolate the active detecting area from the periphery. Using an extraction ring we can separate the charge generated below the p+ layer (which defines the area of the detector) from the charge generated in the periphery, improving the linearity of the signal.

In some embodiments, the highly n-type doped substrate below and in touch with the diode is partially removed by an etching process to reduce "backscattering" of particles and to minimize perturbations to the radiation beam, for instance for beam monitoring applications. The substrate outside this area also must be kept for mechanical stability.

In a further embodiment, the diode is covered by a tissue-equivalent material to simulate the tissue material. These materials could be, but not limited to those, PMMA, polystyrene, etc. Likewise, according to the device of the present invention, both polymers and materials are chosen according to the radiation type (gamma, X-ray, electron, proton or heavy ions).

In another embodiment of the present invention, the metallic layers configured to act as anode and cathode are not made of metals with high atomic number (such as gold) for avoiding the "in-scatter" possible effects when X-ray or gammas FLASH irradiations are used. Usually in the metallic layers with high Z materials (e.g. gold, gadolinium, platinum, silver), when irradiated with X-rays or gamma rays, produce a larger number of Auger electrons (via photoelectric effect) compared to the relatively light elements of biological tissue (hydrogen, carbon, oxygen). This is an emission of secondary radiation that can be detected in the SiC and produce an overresponse of the detector - loss of signal linearity.

In another embodiment of the present invention, a dielectric layer is created through growth or deposition of 800 nm SiO₂ and opened by selective etching.

In another preferred embodiment it comprises:
- a first metallic layer configured to act as a cathode (6) made of at least 3 metals layers stacked selected from Ti, Ni, Au and any combination thereof, preferably is Ti/Ni/Au, wherein said metallic layer has two opposite surfaces, wherein the first surface is configured to be in contact with air, and second surface is configured to be in contact with another layer;
- a n+ substrate layer made of a selected material 4H, 6H or 3C-SiC, preferably 4H-SiC, with highly n-type doped silicon carbide doped with nitrogen configured to act as a n++ region (5) contacting the second surface of the first metallic layer and over the complete or a portion of said surface;
- a n-absorption layer (4) made of intrinsic or lightly n-type doped 4H silicon carbide doped with nitrogen at between 1E13-1E15 cm⁻³, preferably 2E14cm⁻³, with a thickness of between 1 and 100 µm over the n+ layer;
- a p+ layer configured to act as a p++ region (3), made of 4-H silicon carbide doped with aluminum with an optimized profile annealed at high temperature and completely or partially over the n-absorption layer;
- a second metallic layer configured to act as an anode (2) made of at least 4 metals layers stacked selected from Ti, Ni, Al, W and any combination thereof, preferably is Ni/Ti/Al/Ti or Ti/Al/Ti/W, wherein said second metallic layer has two opposite surfaces, wherein the first surface is configured to be in contact with air, and second surface is configured to be in contact completely or partially over the p+ layer;
- a dielectric layer configured to act as insulator layer (1) over at least a peripheral portion of the second metallic layer, and wherein the first surface of second metallic layer region has an opening.

The term "doping" as used herein refers to introducing impurities (in this case N atoms) in the crystal structure of the semiconductor to alter its electrical properties.

The advantages for a 4H-SiC is that 4H has the widest bandgap and almost isotropic electronic mobility.

In a preferred embodiment the n+ substrate layer layer is made of highly n-type doped 4-H SiC with a thickness of 350 µm to 520 µm and doped with nitrogen with a concentration at least 1E19 cm⁻³.

In another preferred embodiment the n-absorption layer is made of lightly n-type doped 4-H SiC with a thickness of 3 µm, doped with nitrogen at a concentration of 2E14 cm⁻³.

In another preferred embodiment the p+ layer is made of 4-H SiC with a graded p-implant created by sequential Al⁺ implantations, followed by a high temperature ramped annealing: ramp of 80 ºC per minute up to 1300 °C and with 60 °C per minute from 1300 ºC to 1670 °C and annealing at 1670°C for 30 minutes. This is in order to obtain a graded p-n junction with the high doping at the interface to form a good ohmic contact.

In another preferred embodiment the dielectric layer is further over the p+ layer and n-absorption layer.

In another preferred embodiment the sidewalls of n-type doped epilayer below the p++ layer is in a mesa geometry.

In another embodiment of the present invention, the dielectric layer is an 800 nm SiO₂ and opened by selective etching.

A second aspect of the present invention is a dosimeter characterized in that it comprises
- at least one detector that comprising the diode described before;
- a readout integrated circuit unit connected to the detector; and
- a processing unit connected to the readout integrated circuit.

A further preferred embodiment a plurality of detectors arranged in a two- dimensional matrix so as to form a "pixel" system to provide information on the dose spatial distribution, either of the configurations described for the acquisition and digitization of the respective output signals are repeated for each detector, and the acquired signals supplied to processing means which are common to all the detectors.

A third aspect of the present invention is the use of the diode described before as a detector under FLASH irradiation conditions.

Unless otherwise defined, all technical and scientific terms used herein have the same meaning as commonly understood by one of ordinary skilled in the art to which this invention belongs. Methods and materials similar or equivalent to those described herein can be used in the practice of the present invention. Throughout the description and claims the word "comprise" and its variations are not intended to exclude other technical features, additives, components, or steps. Additional objects, advantages and features of the invention will become apparent to those skilled in the art upon examination of the description or may be learned by practice of the invention. The following examples, drawings and sequence listing are provided by way of illustration and are not intended to be limiting of the present invention.

### BRIEF DESCRIPTION OF THE DRAWINGS

**Fig. 1****.** Example of PiN diode structure as radiation dosimeter.
**Fig. 2****.** Scheme of the diode dosimeter. It is a PiN diode fabricated on a on a thin lowly n-type doped 4H-SiC epilayer over a highly doped 4H-SiC substrate.
**Fig. 3****.** Process for obtaining the diode.
**Fig. 4****.** A SiC detector under 20MeV electron beam in FLASH in a Gy/pulse.
**Fig. 5****.** Response as a fuction of dose per pulse of prior art Romano 2021, https://www.sensic.ch/fileallegati/ePoster-FRPT-Romano SiC.pdf

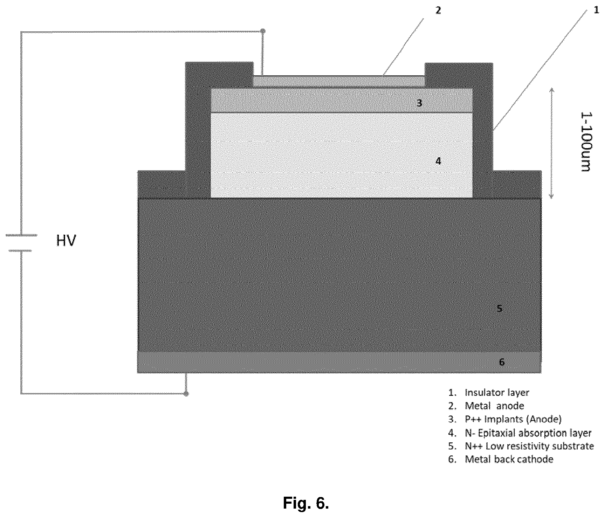

**Fig. 6****.** Scheme of 3D alternative diode dosimeter.

### Examples

### Example 1

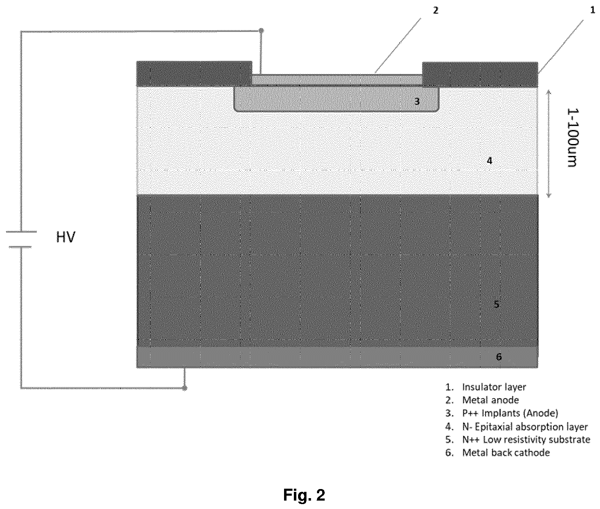

The SiC dosimeter (Fig. 2) is a PiN circular diode fabricated on 4H-SiC on a thin (3 µm) lowly n-type doped (2E14 cm⁻³) epilayer.

The fabrication was done at IMB's clean room.

Al ion implantation was used to form the PiN diode anode, forming a graded junction with the high doping at the interface to form a good enough ohmic contact to optimize the charge collection efficiency.

The dosimeter operates at 0 V or low voltage bias.

The base material is 4H-SiC.

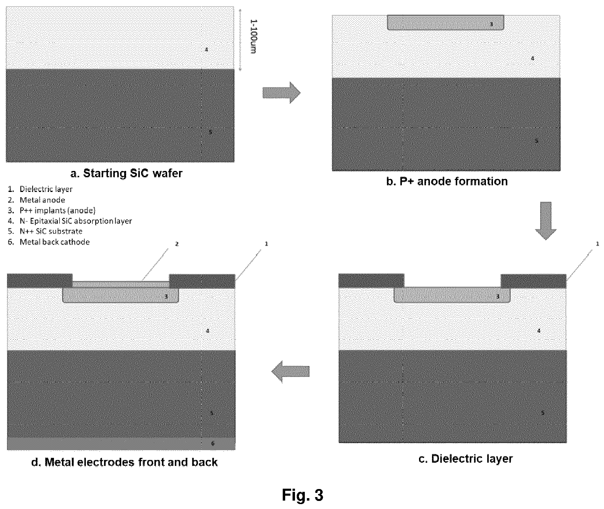

The device is fabricated following the fabrication steps (Fig. 3):
a) The starting SiC wafer is composed of: a n-absorption layer (insulator layer) made of lightly n-type doped epitaxial 4H-SiC doped with nitrogen at 2E14cm⁻³, with a thickness of 3 µm, and a n+ layer made of highly doped n-type 4H-SiC (low resistivity substrate) doped with nitrogen at a concentration of 1E19 cm-3 and a thickness of 350 µm.
b) The p+ anode is created through sequential AI+ ion implantations followed by an annealing temperature ramp of 80 ºC per minute up to 1300 °C and with 60 °C per minute from 1300 ºC to 1670 °C. With a channeling tail control, we obtain a graded junction starting at 0.3 µm depth, with a lower implantation defect formation below the junction area. This lower defect generation enhances the charge collection efficiency of the junction
c) The dielectric layer is created through growth or deposition of 800 nm SiO₂ and opened by selective etching.
d) The low contact resistance ohmic contact is formed in the top surface (anode) with a stack of Ti/Al/Ti/W annealed at 950°C in Ar ambient during 2 minutes. The ratio between Ti and Al layer is key for the reduction of the contact resistance. A second metal layer is formed in the back surface (cathode) with a stack of Ti/Ni/Au.

The semiconductor diode obtained is operated in short-circuit mode. Incident ionizing radiation generates a current by creating pairs in the natural space-charge region that are separated by the internal electric field produced by the built-in potential and also creating excess minority carriers in the neutral regions which diffuse to the depleted region and are collected. The radiation-induced current is proportional to the radiation dose rate and its integral, the total charge collected, is proportional to the absorbed dose in the semiconductor. The obtained diode comprising a first metallic layer configured to act as a cathode (6) of Ti/Ni/Au; a n+ substrate layer made of 4H-SiC configured to act as a n++ region (5) contacting the second surface of the first metallic layer; a n-absorption layer (4) made of intrinsic or lightly n-type doped 4H silicon carbide doped with nitrogen at 2E14cm⁻³ with a thickness of 50 µm over the n+ layer; a p+ layer configured to act as a p++ region (3) contacting a second surface of a second metallic layer, made of 4-H silicon carbide doped with aluminum with an optimized profile annealed at high temperature and completely or partially over the n-absorption layer; a second metallic layer configured to act as an anode (2) made of Ni/Ti/Al/Ti wherein said metallic layer has two opposite surfaces, wherein the first surface is configured to be in contact with air, and second surface is configured to be in contact with the p+ layer and wherein said second surface is partially over the second metallic layer; and a dielectric layer configured to act as insulator layer (1) made of SiO₂ over at least a peripheral portion of said second metallic layer, and wherein the first surface of second metallic layer region has an opening.

### Example 2

Signal linearity of a SiC detector obtained by process described in example 1 and produced at IMB-CNM under 20MeV electron beam in FLASH conditions (unpublished, confidential): p+ layer to produce pn junction is a graded optimized p+ profile achieved by sequential AI+ implantations followed by a high temperature ramped annealing. Detector is operated without bias. Linearity is observed up to at least 11 Gy/pulse.

### Example 3

A comparative example with Romano 2021, https://www.sensic.ch/fileallegati/ePoster-FRPT-Romano SiC.pdf

Comparative example of signal linearity of a SiC detector produced by other company: p+ layer to produce pn junction is a layer with uniform (i.e. not graded optimized profile) p+ doping of 1E19 cm⁻³. Detector needs to be operated at 480 V for proper charge collection. Linearity loss is observed from 4 Gy/pulse.

### Example 4

"3D diode" alternative structure where the sidewalls of the n-type doped epilayer below the p++ layer are removed by etching as a further step of example 1, to obtain a "mesa" geometry, the etching is done in a in a plasma thermal Versaline ICP reactor with two separate RF generators of 13.56 MHz for the coil and substrate bias electrode.

## Claims

1. A SiC based diode configured to receive particles from an accelerator beam with a PiN structure fabricated on a polytype selected from 4H 6H or 3C-SiC with a n-type doped epilayer with a thickness of between 0.1 and 120 µm and a doping concentration of between 1E13 and 1E15 cm⁻³ that comprising at least a first metallic layer configured to act as a cathode, a n+ substrate layer configured to act as a n++ region, a n-absorption layer, a p+ layer configured to act as a p++ region, a second metallic layer configured to act as an anode, and a dielectric layer configured to act as insulator layer **characterized in that** an p+ layer configured to act as a p++ region is obtained by sequential p+ implantations of AI+ followed by an annealing temperature ramp of 80 ºC per minute up to 1300 °C and with 60 °C per minute from 1300 ºC to 1670 °C.

2. A SiC based diode according to claim 1, wherein the annealing at 1670°C is done during 30 minutes.

3. A SiC based diode according to any of claims 1 or 2, wherein first metallic layer configured to act as an anode annealed at 950°C in Ar ambient for 2 minutes.

4. A SiC based diode according to claim 3, wherein the second metallic layer made of at least 4 metals layers stacked selected from Ti, Ni, Al, W and any combination thereof.

5. A SiC based diode according to claim 4, wherein the stack is Ti/Al/Ti/W and the ratio between Ti and Al layer is 1:3 in weight.

6. A SiC based diode according to any of claims 1 to 5, wherein the sidewalls of n-type doped epilayer below the p++ layer are removed by etching to obtain a "mesa" geometry.

7. A SiC diode according to any of claims 1 to 6, wherein it comprises:
• a first metallic layer configured to act as a cathode (6) made of at least 3 metals layers stacked selected from Ti, Ni, Au and any combination thereof, preferably is Ti/Ni/Au, wherein said metallic layer has two opposite surfaces, wherein the first surface is configured to be in contact with air, and second surface is configured to be in contact with another layer;
• a n+ substrate layer made of a selected material 4H, 6H or 3C-SiC, preferably 4H-SiC, with highly n-type doped silicon carbide doped with nitrogen configured to act as a n++ region (5) contacting the second surface of the first metallic layer and over the complete or a portion of said surface;
• a n-absorption layer (4) made of intrinsic or lightly n-type doped 4H silicon carbide doped with nitrogen at between 1E13-1E15 cm⁻³, preferably 2E14cm⁻³, with a thickness of between 1 and 100 µm over the n+ layer;
• a p+ layer configured to act as a p++ region (3), made of 4-H silicon carbide doped with aluminum with an optimized profile annealed at high temperature and completely or partially over the n-absorption layer;
• a second metallic layer configured to act as an anode (2) made of at least 4 metals layers stacked selected from Ti, Ni, Al, W and any combination thereof, preferably is Ni/Ti/Al/Ti or Ti/Al/Ti/W, wherein said second metallic layer has two opposite surfaces, wherein the first surface is configured to be in contact with air, and second surface is configured to be in contact completely or partially over the p+ layer;
• a dielectric layer configured to act as insulator layer (1) over at least a peripheral portion of the second metallic layer, and wherein the first surface of second metallic layer region has an opening.

8. A SiC diode according to claim 7, wherein the n+ substrate layer is made of highly n-type doped 4-H SiC with a thickness of 350 µm and doped with nitrogen with a concentration of 1E19 cm⁻³.

9. A SiC diode according to any of claims 7 or 8, wherein the n-absorption layer is made of lowly n-type doped 4-H SiC with a thickness of 3 µm, doped with nitrogen at a concentration of 2E14 cm⁻³.

10. A SiC diode according to any of claims 7 to 9, wherein p+ layer is made of 4-H SiC with a graded p-implant created by sequential Al⁺ implantations.

11. A SiC diode according to any of claims 7 to 10, wherein the dielectric layer is further over the p+ layer and n-absorption layer.

12. A SiC diode according to any of claims 7 to 10, wherein the sidewalls of n-type doped epilayer below the p++ layer is in a mesa geometry.

13. A dosimeter **characterized in that** it comprises
• at least one detector that comprising the diode according to any of claims 1 to 12;
• a readout integrated circuit unit connected to the detector; and
• a processing unit connected to the readout integrated circuit.

14. A dosimeter according to claim 13, wherein a plurality of detectors arranged in a two- dimensional matrix so as to form a "pixel" system to provide information on the dose spatial distribution, either of the configurations described for the acquisition and digitalization of the respective output signals are repeated for each detector, and the acquired signals supplied to processing means which are common to all the detectors.

15. Use of the diode according to any of claims 1 to 12 as a detector under FLASH irradiation conditions.
